# EUROPEAN PATENT SPECIFICATION

(11) **EP 3 997 734 B1**
(45) Date of publication and mention of the grant of the patent: **08.11.2023**
(21) Application number: 20750053.9
(22) Date of filing: 09.07.2020
(51) Int. Cl.: H01L 25/075, H01L 33/00, H01L 33/62

(54) **REDUCING THE PLANARITY VARIATION IN A DISPLAY DEVICE**
REDUZIERUNG DER VARIATION DER PLANARITÄT IN EINER ANZEIGEVORRICHTUNG
RÉDUCTION DE VARIATION DE LA PLANARITÉ DANS UN DISPOSITIF D'AFFICHAGE

(30) Priority: 10.07.2019 US 201962872573 P; 22.07.2019 US 201962877119 P; 15.01.2020 US 202016742973
(43) Date of publication of application: 18.05.2022
(73) Proprietor: Facebook Technologies, LLC, Menlo Park, CA 94025 (US)
(72) Inventor: PENDSE, Rajendra D., Menlo Park, California 94025 (US)
(74) Representative: Murgitroyd & Company
(86) International application number: PCT/US2020/041440
(87) International publication number: WO 2021/007452

(56) References cited:
- EP-A1- 3 425 618
- US-A1- 2006 002 110
- US-A1- 2011 298 021
- US-A1- 2015 001 703
- US-A1- 2018 019 234
- US-A1- 2018 114 878
- US-A1- 2018 269 191
- US-A1- 2018 312 731

## Description

### BACKGROUND

The disclosure relates generally to display, and more specifically, to integration of display devices with control circuits.

Displays are ubiquitous and are a core component of wearable devices, smart phones, tablets, laptops, desktops, TVs and display systems. Common display technologies today include Light Emitting Diode (LED) displays. A display device can include a plurality of LED dies that are mounted on a backplane.

Document EP 3 425 618 A1 discloses a method for manufacturing a semiconductor device, which includes forming an insulating film containing silicon, oxygen and carbon on at least one of a first substrate and a second substrate and bonding the first substrate and the second substrate together, with the insulating film interposed therebetween.

### SUMMARY

The present disclosure generally relates to reducing a variation in the planarity of a display device. According to the present invention, there is disclosed a method as recited in claim 1.

The first pressure is provided solely by a weight of a material that is placed on the top surface of the display device. The first temperature may correspond to a melting point of the plurality of fusible interconnections. A bottom surface of the material that contacts the top surface of the display device may be flat. Alternatively, a bottom surface of the material that contacts the top surface of the display device may be curved. A curvature of the bottom surface of the material may be determined based on a warpage of the top surface of the display device that is predicted to occur after a reflow of a fusible material that forms the plurality of fusible interconnections.

Alternatively, the first pressure may correspond to a yield strength of a fusible material of the plurality of fusible interconnections at room temperature, and the first pressure may be provided by a weight of a material that is placed on the top surface of the display device and an external force that is applied to the material. The first temperature may correspond to the room temperature. A bottom surface of the material that contacts the top surface of the display device may be flat. Alternatively, a bottom surface of the material that contacts the top surface of the display device may be curved. The fusible material may include solder.

The method may also include applying a second pressure to the top surface of the display device at a second temperature. The second pressure may be applied after the first pressure is applied. The second pressure may be applied in the direction that is perpendicular to the plane of the backplane on which the plurality of dies are arranged. The second pressure and the second temperature are selected to cause the plurality of fusible interconnections to absorb further variations in the planarity of the top surface of the display device. The first pressure may be provided solely by a weight of a material that is placed on the top surface of the display device, and the second pressure may be provided by the weight of the material that is placed on the top surface of the display device and an external force that is applied to the material.

The method may also include applying a protective film to the top surface of the display device before applying the first pressure to the top surface of the display device. The protective film may include an electronic grade Si film adhesive or a thermoplastic material. The display device may also include at least one spacer that is arranged adjacent to the plurality of dies. The fusible material of the plurality of the fusible interconnections may comprise solder.

In some embodiments, a display device includes a backplane, a plurality of dies, and a plurality of fusible interconnections between the backplane and the plurality of dies. Each die of the plurality of dies includes a plurality of light emitting diodes. A planarity variation of a top surface of the display device is less than 10 µm. The display device may also include at least one spacer that is arranged adjacent to the plurality of dies.

### BRIEF DESCRIPTION OF THE DRAWINGS

Illustrative embodiments are described with reference to the following figures:
**FIG. 1** shows a cross-sectional view of an example LED device that can be manufactured using examples of the disclosed techniques.
**FIG. 2A, FIG. 2B****,** **FIG. 2C, FIG. 2D****,** **FIG. 2E****, and** **FIG. 2F** are schematic views of an example display that can be manufactured using examples of the disclosed techniques.
**FIG. 3** illustrates an example of a display device, according to examples of the disclosed techniques.
**FIG. 4A** and **FIG. 4B** illustrate examples of the display device of **FIG. 3**, according to examples of the disclosed techniques.
**FIG. 5A** and **FIG. 5B** illustrate examples of the display device of **FIG. 3**, according to examples of the disclosed techniques.
**FIG. 6** illustrates examples of the display device of **FIG. 3**, according to examples of the disclosed techniques.
**FIG. 7A****,** **FIG. 7B****,** **FIG. 7C****,** and **FIG. 7D** illustrate examples of the display device of **FIG. 3**, according to examples of the disclosed techniques.
**FIG. 8** illustrates an example of a method for manufacturing a display device, according to examples of the disclosed techniques.
**FIG. 9A, FIG. 9B, and FIG. 9C** illustrate an example of a method for reducing the planarity variation in a display device.

The figures depict embodiments of the present disclosure for purposes of illustration only. One skilled in the art will readily recognize from the following description that alternative embodiments of the structures and methods illustrated may be employed without departing from the principles, or benefits touted, of this disclosure.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

### DETAILED DESCRIPTION

In the following description, for the purposes of explanation, specific details are set forth in order to provide a thorough understanding of certain embodiments However, it will be apparent that various embodiments may be practiced without these specific details. The figures and description are not intended to be restrictive.

Common display technologies today range from Liquid Crystal Displays (LCDs) to more recent Organic Light Emitting Diode (OLED) displays and Active Matrix Organic Light Emitting Diode (AMOLED) displays. Inorganic Light Emitting Diodes (ILEDs) are emerging as the third generation of flat display image generators based on superior battery performance and enhanced brightness. A "µLED," "uLED," or "MicroLED," described herein refers to a particular type of ILED having a small active light emitting area (e.g., less than 2,000 µm) and, in some examples, being capable of generating directional light to increase the brightness level of light emitted from the small active light emitting area. In some examples, a micro-LED may refer to an LED that has an active light emitting area that is less than 50 µm, less than 20 µm, or less than 10 µm. In some examples, the linear dimension may be as small as 2 µm or 4 µm. For the rest of the disclosure, "LED" may refer µLED, ILED, OLED, or any type of LED devices.

ILED displays can be manufactured using different processes from OLED displays. For example, OLED devices are fabricated directly onto a display substrate. In contrast, ILED devices are fabricated separately from the display substrate. The base material of ILED devices base material is grown on a crystalline substrate to form an LED starter wafer. The LED starter wafer can be processed through various steps to produce individual LED dies, with each LED die including an LED device. Once fabricated, the LED dies can be transferred from the carrier substrate to a backplane. The backplane can be a display backplane of a display device. The LED devices of the display device can be divided to form pixels.

The backplane, as well as other components such as control circuits and power system can be individually attached to a circuit board (e.g., a printed circuit board (PCB)) to form a display system. The circuit board can provide electrical connections among the different components of the display system. Such arrangements can be undesirable. First, as the components are spaced apart by relatively long distances, the form factor of the display system increases, which makes it difficult to deploy the display system in devices with very limited spaces, such as a wearable device. Second, long signal traces are needed to provide the electrical connections among the components. The long signal traces can add substantial delay to the transmission of high speed signals, such as high resolution image data, which can significantly degrade the performance of the display system. All these can limit the applications of the display system.

Examples of the present disclosure provide a display apparatus. The display apparatus comprises an integrated circuit (IC) chip. The IC chip comprises light emitting diode (LED) devices, a first die, and a second die integrated within the IC chip. The LED devices are exposed on a front side of the IC chip. The IC chip further includes input/output (I/O) bumps on a back side of the IC chip. The LED devices can form a stack with the first die along a vertical direction. The first die includes driver circuits electrically connected to the LED devices and is electrically connected to at least some of the I/O bumps. The IC chip further includes a first circuit that extends along the vertical direction from the front side of the IC chip towards a back side of the IC chip and across at least a thickness of the first die to provide electrical connections between the LED devices and at least some of the I/O bumps. The second die, which comprises a display engine and control circuits for the driver circuits of the first die, is connected to at least some of the I/O bumps. The IC chip further includes a second circuit to provide electrical connections between the first die and the second die. The display apparatus further comprises a circuit board electrically connected to the input/output bumps of the IC chip and to a power system to provide electrical connections between the power system and each of the first die, the second die, and the LED devices of the IC chip.

For the rest of the disclosure, a "circuit" can include any structure that can conduct an electrical current or can transmit an electrical potential. A circuit can include, for example, a wire, a via, as well as any passive or active devices (e.g., a resistor, a capacitor, an inductor, a transistor, etc.)

In some examples, the first die and the second die can be arranged along a lateral direction within the IC chip. The IC chip may include a shoulder structure abutting the first die along the lateral direction. The shoulder structure may include electrical conduction paths that extend across the shoulder structure from the front side of the IC chip to the back side of the IC chip to provide electrical connections between the LED devices and the I/O bumps. The IC chip may include fan-out circuits configured as a front side redistribution layer (RDL) adjacent to the LED devices and on the front side of the IC chip. The front side RDL can extend from the shoulder structure to the first die to provide electrical connections between a first end of the electrical conduction paths and the first die. The first die further includes an inner layer circuit to provide electrical connection between the first end of the electrical conduction paths and the LED devices. The IC chip may also include another front side RDL that extends from the second die over to the first die to provide electrical connections between the first die and the second die.

Various configurations are proposed to connect a second end of the electrical paths of the shoulder structure to the I/O bumps on the back side of the IC chip. In one example, the I/O bumps can be formed on part of the shoulder structure on the back side of the IC chip to electrically connect to the second end of the electrical conduction paths. In another example, the IC chip may include fan-out circuits configured as a back side RDL opposite to the front side RDL. The I/O bumps can be formed on the backside RDL, and the backside RDL can extend from the I/O bumps to the shoulder structure to provide electrical connections between the I/O bumps and the second end of the electrical conduction paths.

In some examples, the first die and the second die can form a stack along the vertical direction within the IC chip. The IC chip may include a first shoulder structure abutting the first die along the lateral direction and a second shoulder structure abutting the second die along the lateral direction. The first shoulder structure may include first electrical conduction paths that extend across the first shoulder structure along the vertical direction. The second shoulder structure may include second electrical conduction paths that extend across the second shoulder structure along the vertical direction. The first die may include a first front side RDL adjacent to the LED devices. The first front side RDL extends from the first shoulder structure to the first die to provide electrical connections between the LED devices and the first electrical conduction paths via the first die. In some examples, the first shoulder structure in the first die may be replaced by through silicon vias (TSVs) within the body of the first die itself. The TSVs may be in the perimeter region of the first die or within substantially an entire area of the first die.

Various configurations are proposed to provide electrical connections between the first shoulder structure and the second shoulder structure. In one example, the first electrical conduction paths and the second electrical conduction paths can be electrically connected together via I/O bumps sandwiched between the first shoulder structure and the second shoulder structure. In some examples, the IC chip may include opposite RDL layers formed on, respectively, a backside of the first die (facing away from the front side of the IC chip) and a front side of the second die facing the backside of the first die. The opposite RDL layers can extend to, respectively, the first shoulder structure and the second shoulder structure to provide electrically connections to, respectively, the first electrical conduction paths of the first shoulder structure and the second electrical conduction paths of the second shoulder structure. The IC chip may include I/O bumps sandwiched between the opposite RDL layers to provide electrical connections between the opposite RDL layers and between the first electrical conduction paths and the second electrical conduction paths. The I/O bumps on the back side of the IC chip can be located on the second shoulder structure, or on another backside RDL that extends over the second chip, as described above.

Other configurations are also proposed to integrate the LED devices and the dies in an integrated circuit chip. In one example, the IC chip may include a chip carrier to hold the first die and the second die arranged along the lateral direction. The chip carrier may include electrical conduction paths to provide electrical connections to the I/O bumps on the back side of the IC chip. The IC chip may include bridge circuits to provide electrical connections between the LED devices and the electrical conduction paths within the chip carrier. In another example, the IC chip may include the first die and the second die forming a stack along the vertical direction, and each of the first die and the second die may include through silicon vias (TSVs) to provide electrical connections between the LED devices and the I/O bumps on the back side.

With the disclosed techniques, the LED devices and the control circuits can be integrated in a single integrated circuit chip. Such arrangements can substantially reduce the separation distances between the components of a display system, which reduces not only the form factor of the display system but also the routing distances, and the operation speed of the display system can be improved as a result. The disclosed techniques are particularly advantageous for implementation of a high performance display system in a wearable device (e.g., a head mount display) which has very limited space.

Examples of the disclosure may include or be implemented in conjunction with an artificial reality system. Artificial reality is a form of reality that has been adjusted in some manner before presentation to a user, which may include, e.g., a virtual reality (VR), an augmented reality (AR), a mixed reality (MR), a hybrid reality, or some combination and/or derivatives thereof. Artificial reality content may include completely generated content or generated content combined with captured (e.g., real-world) content. The artificial reality content may include video, audio, haptic feedback, or some combination thereof, any of which may be presented in a single channel or in multiple channels (such as stereo video that produces a three-dimensional effect to the viewer). Additionally, in some examples, artificial reality may also be associated with applications, products, accessories, services, or some combination thereof, that are used to, e.g., create content in an artificial reality and/or are otherwise used in (e.g., perform activities in) an artificial reality. The artificial reality system that provides the artificial reality content may be implemented on various platforms, including a head-mounted display (HMD) connected to a host computer system, a standalone HMD, a mobile device or computing system, or any other hardware platform capable of providing artificial reality content to one or more viewers.

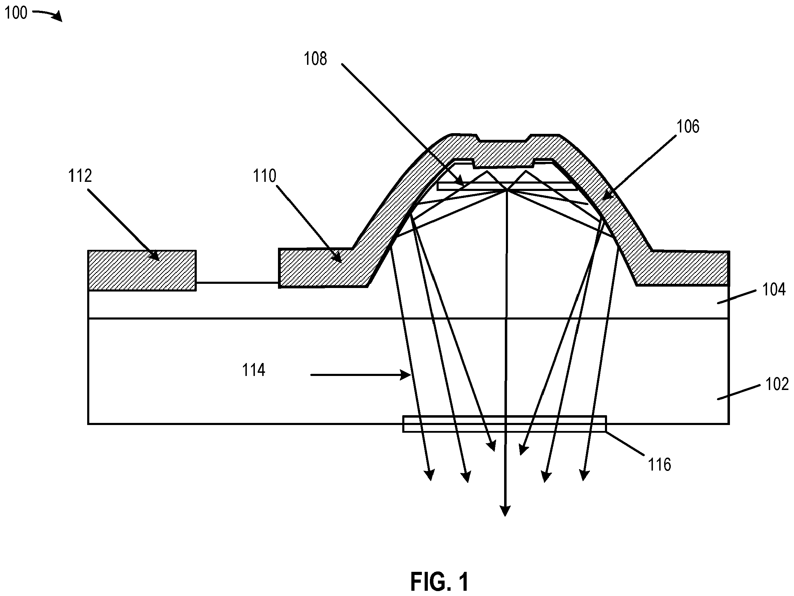

**FIG. 1** shows a cross-sectional view of a µLED 100 according to some examples of the present disclosure. As shown in **FIG. 1**, µLED 100 includes, among others, a substrate 102, a semiconductor epitaxial layer 104 disposed on the substrate 102. Epitaxial layer 104 can be shaped into a mesa 106. An active layer 108, which can include quantum well structures configured to emit light of a pre-determined wavelength range when activated, can be included in mesa 106. Mesa 106 has a truncated top covered by a P-type contact pad 110, whereas a part of epitaxial layer 104 outside of mesa 106 may be covered by an N-type contact pad 112. An electric signal can be applied across P-type contact pad 110 and N-type contact pad 112 to activate active layer 108 to emit light 114. Moreover, mesa 106 also has a near-parabolic shape to form a reflective enclosure. The near-parabolic structure of mesa 106 can be etched directly onto the LED die during the wafer processing steps. Mesa 106 for a typical µLED can have a diameter of about 50 micrometers (µm) or less, whereas each of P-type contact pad 110 and N-type contact pad 112 may have a diameter of about 20 µm.

Light 114 emitted from active layer 108 can be reflected off the internal walls of mesa 106 toward light emitting surface 116 at an angle sufficient for the light to escape the µLED die 100 (i.e., within an angle of total internal reflection). Light 114 can form a quasi-collimated light beam as the light emerges from light emitting surface 116.

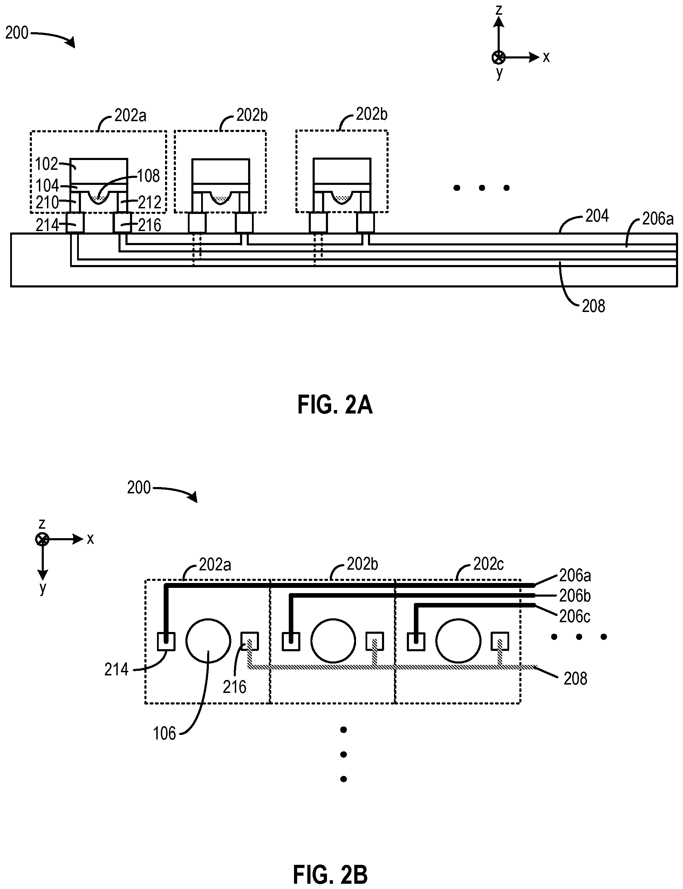

**FIG. 2A** and **FIG. 2B** show an example of a µLED display apparatus 200 according to some examples of the present disclosure. Although the examples of **FIG. 2A** and **FIG. 2B** are based on µLED devices, it is understood that the examples of **FIG. 2A** and **FIG. 2B** are applicable to other types of LED devices as well. **FIG. 2A** shows a cross-sectional view of the display apparatus, whereas **FIG. 2B** shows a top view of the display apparatus. As shown in **FIG. 2A**, µLED display 200 can include an array of µLED dies 202 including, for example, µLED die 202a, µLED die 202b, and µLED die 202c assembled on a backplane 204.

Backplane 204 may include a structure for attaching a plurality of µLED dies, to provide electrical connections and structural support for the plurality of µLED devices. As used herein, "backplane" may refer to any structure that provides a surface (which can be planar, curved, etc.) for attaching a plurality of LED devices (which may include µLED devices as described in this disclosure) and for providing electrical signals to the plurality of LED devices. The backplane can be configured as a display backplane to form a display device. For example, the backplane can hold assemblies of LED devices forming display elements, and the backplane may also include traces to provide electrical signals to the LED devices to control the information displayed by the display elements. Backplane 204 may comprise traces, which may connect to other components. Backplane may also comprise electrical contact points, e.g., metal pads, which may provide access to the traces. For example, as shown in **FIG. 2A** and **FIG. 2B**, backplane 204 includes electrical traces 206a, 206b, and 206c to electrically connect with, respectively, µLED die 202a, µLED die 202b, and µLED die 202c. Electrical traces 206a, 206b, and 206c allow each of µLED die 202a, µLED die 202b, and µLED die 202c to be individually controlled by applying different signals. Backplane 204 also includes an electrical trace 208 to act as a return current path for each of µLED die 202a, µLED die 202b, and µLED die 202c. Backplane 204 may include different kinds of materials, such as Thin Film Transistor (TFT) glass substrate, polymer, polychlorinated biphenyl (PCB), etc. Although FIG. 2A illustrates that backplane 204 has a rectangular shape, it is understood that backplane 204 can have various shapes and sizes.

Each of µLED die 202a, µLED die 202b, and µLED die 202c can have a structure similar to µLED die 100 of **FIG. 1****.** Each µLED die in **FIG. 2A** and **FIG. 2B** may include substrate 102, epitaxial layer 104, mesa 106, and active layer 108. In addition, each µLED die includes a device-side bump 210 and a device-side bump 212. While **FIG. 2A** and **FIG. 2B** illustrate that the bumps are of rectangular shape, it is understood that the bumps can take on other shapes including, for example, rounded shapes, dome shapes, etc. Device-side bump 210 can be connected to P-type contact pad 110 (not shown in **FIG. 2A** and **FIG. 2B**), whereas device-side bump 212 can be connected to N-type contact pad 112 (also not shown in **FIG. 2A** and **FIG. 2B**). Moreover, backplane 204 includes backplane-side bumps at each location for placing a µLED die. For example, backplane 204 includes backplane-side bumps 214 and 216 for µLED die 202a. Backplane 204 also includes metal pads (not shown in FIG. 2A) which serve as a foundation on which backplane-side bumps 214 and 216 are deposited, and to provide electrical contact to traces 206 and 208. Conductive bonding (e.g., metallic bonding) can be formed between the bumps of the µLED dies and the contacts to provide electrical paths between the µLED die and backplane 204.

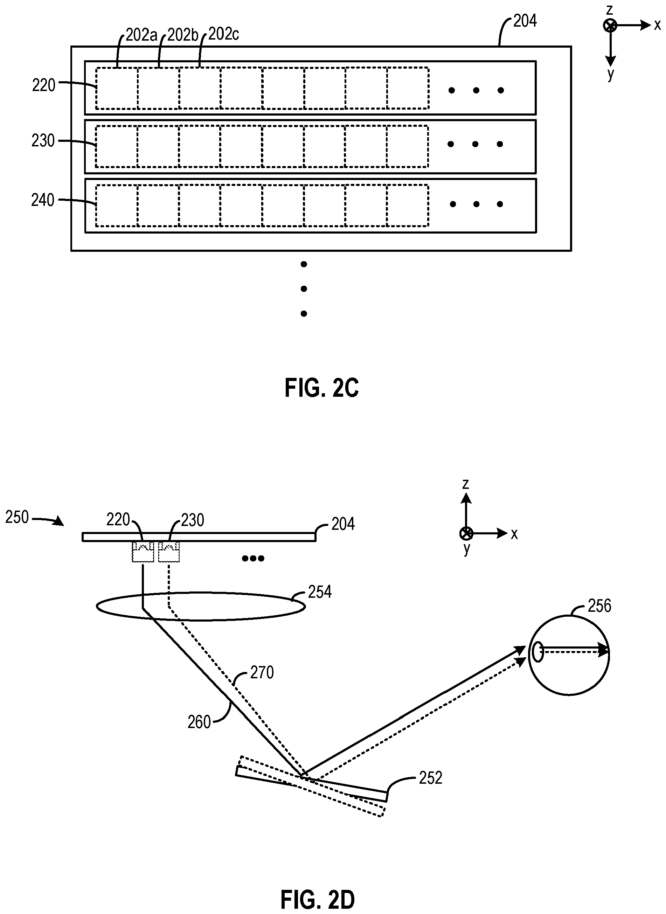

In some examples, µLED display apparatus 200 can be configured as a scanning display in which the LEDs configured to emit light of a particular color are formed as a strip (or multiple strips). For example, as shown in **FIG. 2C**, a plurality of µLED dies including µLED die 202a, µLED die 202b, and µLED die 202c, etc. can be assembled along an X-axis to form a µLED strip 220 configured to emit green light on backplane 204. In addition, backplane 204 also includes a µLED strip 230 configured to emit red light and an LED strip 240 configured to emit blue light.

µLED strips 220, 230, and 240, as well as additional strips of red, green and blue µLEDs, can be assembled along a Y-axis as parallel strips on backplane 204 to form a scanning display. **FIG. 2D** illustrates an example of a scanning display 250 comprising µLED display apparatus 200, a mirror 252, and a lens 254. In scanning display 250, each strip of LEDs can be configured to emit light of a particular color (e.g., one of red, green, or blue). For example, µLED strip 220 can emit green light 260, µLED strip 230 can emit red light 270, etc. The lights can be converged by lens 254 and reflected by mirror 252 into eyeball 256 of a person. To perform sequential scanning, each strip of µLEDs can be controlled to emit light to project a line of pixels of an image onto the retina of eyeball 256. The projection of each line of pixels can be sequential. Through the rotating action of mirror 252, each line of pixels can be projected at different points at different times on the retina, to create the perception of the image.

In the examples of **FIG. 2A****-****FIG. 2D****,** backplane 204 has backplane-side bumps for each µLED to transmit control signals to each µLED. Such arrangement, while allowing each µLED to be individually controlled, can lead to a large number of backplane-side bumps being placed on the backplane when the display includes a large number of pixels to improve resolution. For example, if scanning display 250 includes one million µLEDs, one million pairs of backside-bumps 214 and 216 need to be provided on backplane 204 to provide electrical connections to each of the one million µLEDs. Additional wirings 206 and 208 are also needed on backplane 204 to provide electrical connections to the backside-bumps.

The large number of bumps and the associated wirings can degrade the tight integration between the LED devices and the control circuits. For example, additional backplane spaces may be needed to place the bumps, which can increase the distances between the LED devices and the control circuits. As signals need to travel through longer distances, the operation speeds of both the LED devices and the control circuits can be reduced as a result.

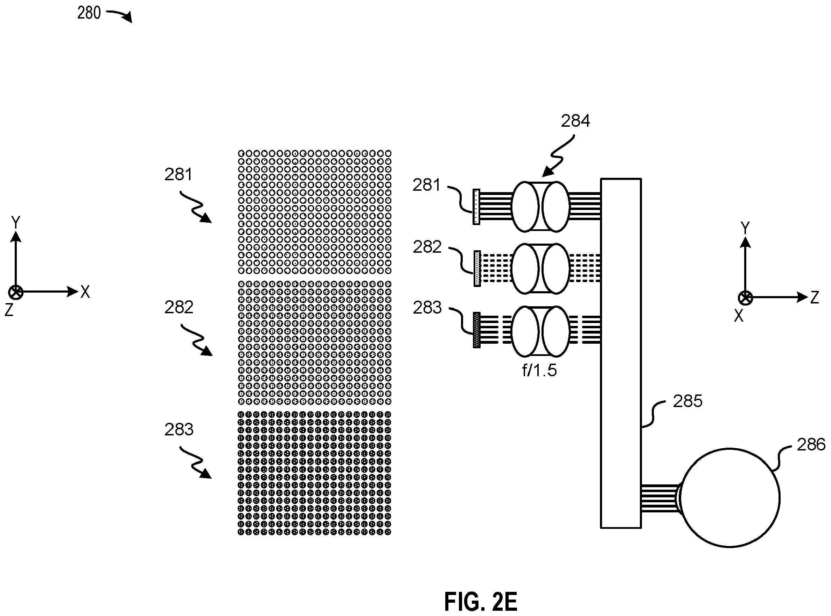

**FIG. 2E** illustrates an example of a display device 280 that includes three arrays of LEDs that are coupled to a waveguide. The LEDs may be µLEDs. As shown on the lefthand side of **FIG. 2E**, the display device 280 may include a first array 281 of LEDs that are configured to emit red light, a second array 282 of LEDs that are configured to emit green light, and a third array 283 of LEDs that are configured to emit blue light. As shown on the right-hand side of **FIG. 2E**, collimating lenses 284 may be provided to collimate light from each of the arrays 281, 282, and 283 of LEDs. One collimating lens 284 may be provided for each array 281, 282, and 283 of LEDs. Further, a single waveguide 285 may be provided to receive light from the collimating lenses 284 and to direct light toward the user's eye 286.

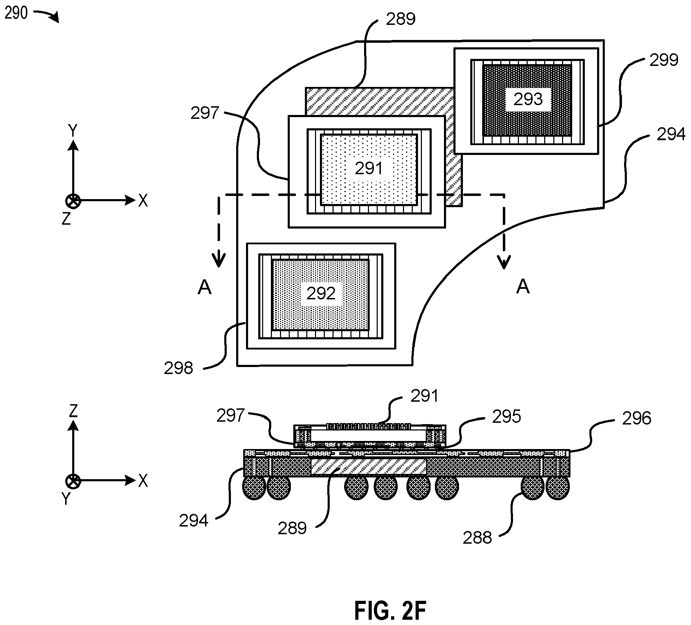

**FIG. 2F** illustrates an example of a display device 290 that includes three arrays of LEDs that are coupled to a waveguide. The LEDs may be µLEDs. As shown in the top portion of **FIG. 2F**, display device 290 may include die 291, die 292, and die 293, which are mounted on a backplane 294 via I/O bumps 295. The dies 291, 292, and 293 may be LED dies. Die 291 may include an array of LEDs that are configured to emit red light, such as the first array 281 of LEDs shown in **FIG. 2E****.** Die 292 may include an array of LEDs that are configured to emit green light, such as the second array 282 of LEDs shown in **FIG. 2E****.** Die 293 may include an array of LEDs that are configured to emit blue light, such as the third array 283 of LEDs shown in **FIG. 2E****.** The dies 291, 292, and 293 are configured to be co-planar along the z direction, but may be staggered in any suitable configuration along the x direction and/or the y direction. A first additional layer 297, such as a first fan-out circuit, may be provided between die 291 and the backplane 294. A second additional layer 298, such as a second fan-out circuit, may be provided between die 292 and the backplane 294. A third additional layer 299, such as a third fan-out circuit, may be provided between die 293 and the backplane 294. The backplane 294 may have driver and graphics functions. The backplane 294 may include a backplane die 289 that is positioned underneath at least one of the dies 291, 292, or 293, and that drives the dies 291, 292, and 293.

The bottom portion of **FIG. 2F** shows a cross-section taken along line A-A labeled in the top portion of **FIG. 2F****.** As shown in the bottom portion of **FIG. 2F**, a redistribution layer 296 may be provided to allow the dies 291, 292, and 293 to interface with the backplane die 289 such that the dies 291, 292, and 293 are not required to be positioned entirely or exactly on top of the backplane die 289. Additional I/O bumps 288 may be provided on the underside of the backplane 294 in order to provide a connection between the backplane 294 and a sensor aggregation chip (not shown), and to supply power to the integrated circuit, including the dies 291, 292, and 293.

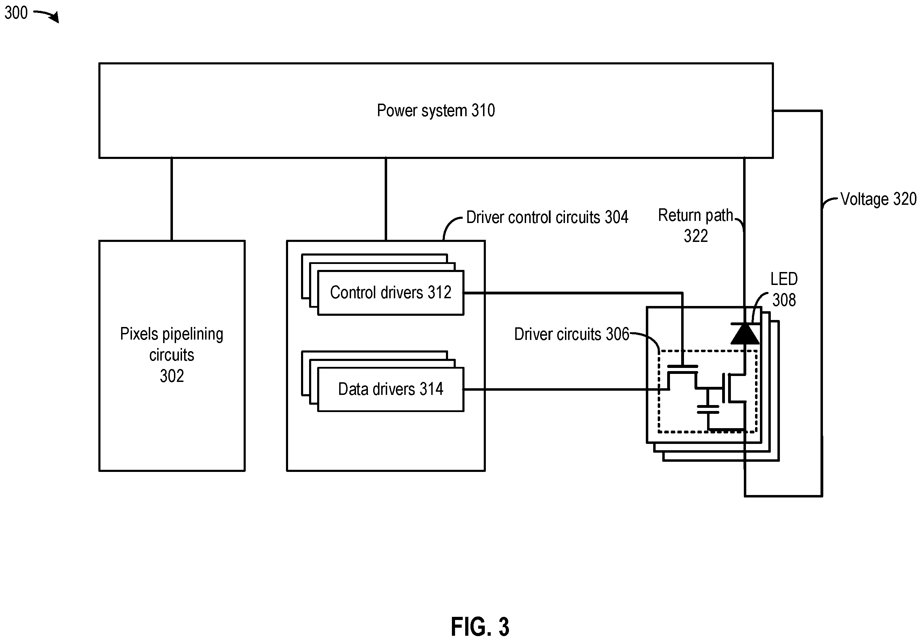

**FIG. 3** illustrates an example of a display system 300 that can be part of or include µLED display apparatus 200. As shown in **FIG. 3**, display system 300 includes pixel pipelining circuits 302, driver control circuits 304, driver circuits 306, an array of uLED devices 308, and power system 310. Pixel pipelining circuits 302 can generate pixel data to be rendered by display system 300. Pixel data can include, for example, an image of a virtual reality scene, a composite image of a mixed reality scene, an image captured by a camera, etc. Driver control circuits 304 can generate control signals and data signals for driver circuits 306 based on the pixel data. The control signals can include, for example, address signals to select a uLED device among the array of uLED devices 308. The data signals can set an output intensity of the selected uLED device. Both address signals and data signals can be high speed signals to allow display system 300 to display images at a high resolution and at a high refresh rate. Typically both pixel pipelining circuits 302 and driver control circuits 304 are fabricated using process technologies that support high speed operations and relatively low operation voltages.

In addition, as shown in **FIG. 3**, driver circuits 306 may include a set of control drivers 312 to provide the control signals and a set of data drivers 314 to provide the data signals. Driver circuits 306 can receive the address and data signals from driver control circuits 304 and control the output intensities of the uLED devices based on, for example, controlling the currents that flow through the uLED devices based on the data signals. As shown in **FIG. 3**, driver circuits 306 may include transistors and capacitors controlled by the control signals and data signals to control the flow of current in the uLED devices. Typically driver circuits 306 are fabricated using process technologies that support high operation voltages and relatively low speed operations.

Power system 310 may include a power supply circuit (e.g., a voltage regulator), as well as other elements (e.g., voltage supply line, ground line, etc.). As shown in **FIG. 3**, power system 310 can be electrically connected to each of pixel pipelining circuits 302, driver control circuits 304, and driver circuits 306, to, for example, supply electric power (e.g., voltage 320) and/or provide a current return path. Power system 310 also provides a return path 322 for uLED devices 308.

As described above, it is advantageous to integrate pixel pipelining circuits 302, driver control circuits 304, driver circuits 306, and uLED devices 308 within a single integrated circuit chip to reduce the separation distances between these components. Such arrangements can reduce the form factor of the display system as well as the routing distances and improves the operation speed of the display system.

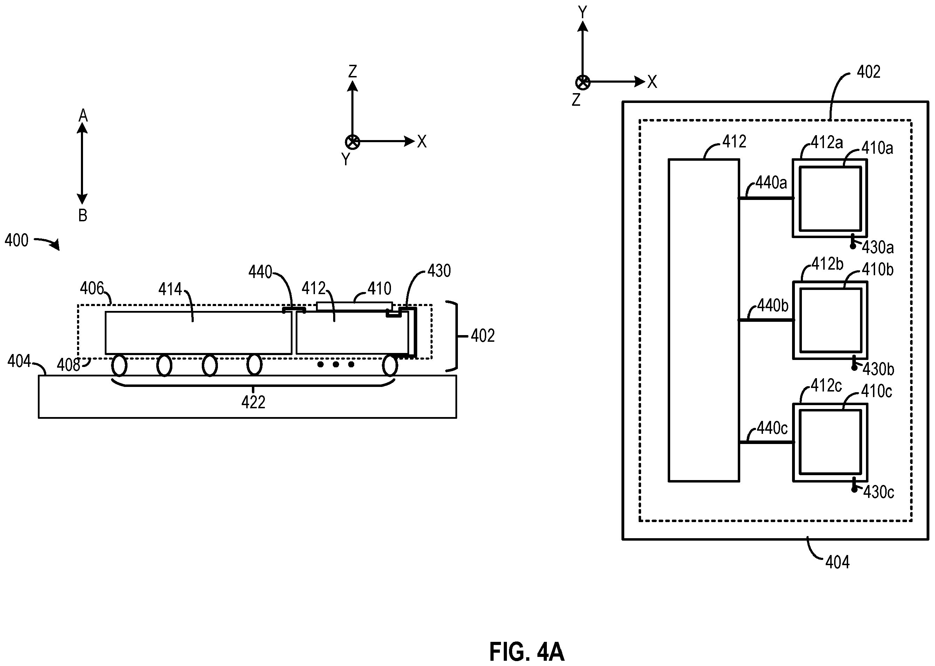

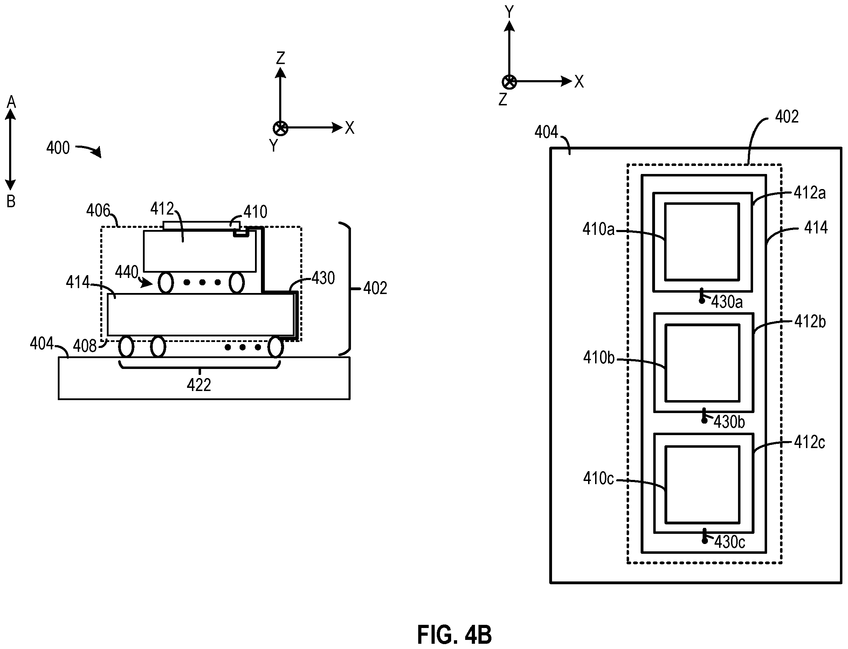

**FIG. 4A** and **FIG. 4B** illustrate example of a display system 400 that can provide improved performance and reduced form factors. The left diagram of **FIG. 4A** illustrates a side view of an example of a display system 400, whereas the right diagram of **FIG. 4A** illustrates a top view of display system 400. Referring to **FIG. 4A****,** a display system 400 can include an integrated circuit (IC) chip 402 and a circuit board 404. Integrated circuit chip 402 includes a front side 406 (facing towards direction "A") and a back side 408 (facing towards direction "B"). IC chip 402 includes light emitting diode (LED) devices 410, a first die 412, and a second die 414 integrated within IC chip 402. LED devices 410 are exposed on the front side of the IC chip. IC chip 402 further includes input/output (I/O) bumps 422 on back side 408. LED devices 410 can form a stack with first die 412 along a vertical direction (e.g., along the Z axis). First die 412 can include, for example, driver circuits 306 of **FIG. 3****.** Driver circuits 306 can be electrically connected to some of I/O bumps 422. As shown on the right of **FIG. 4A**, IC chip 402 may include a plurality of first dies 412 coupled with LED devices 410 of different colors. For example, first die 412a can form a stack with red LED devices 410a, first die 412b can form a stack with green LED devices 410b, whereas first die 412c can form a stack with blue LED devices 410c. Second die 414 may include, for example, pixel pipelining circuits 302 and driver control circuits 304. Pixel pipelining circuits 302 and driver control circuits 304 can be connected to some of I/O bumps 422 as well. First die 412 and second die 414 can be fabricated from different wafers associated with, for example, different processing nodes, different operation voltages, etc. For example, first die 412 can be fabricated using a process node that tolerates higher operation voltage but supports lower speed operations, whereas second die 414 can be fabricated using a process node that supports higher speed operations but have lower operation voltage limits.

In addition, IC chip 402 includes a first circuit 430 and a second circuit 440. Both first circuit 430 and second circuit 440 may include wires, traces, vias, etc., to provide electrical connections. First circuit 430 (e.g., first circuits 430a, 430b, 430c, etc.) can extend along the vertical direction from front side 408 of IC chip 402 towards back side 408 of IC chip 402 and across at least a thickness of first die 412. That is, the vertical distance covered by first circuit 430 may span at least the thickness of first die 412. However, first circuit 430 may or may not actually physically go through the first die 412, depending on the embodiment adopted. For example, in the embodiment shown in FIG. 4A, first circuit 430 extends vertically across at least the thickness of first die 412, without physically going through first die 412. First circuit 430 can include an inner layer circuit in first die 412 to electrically connect to LED devices 410. First circuit 430 can be configured as a wrap-around circuit to provide electrical connections between LED devices 410 and at least some of I/O bumps 422. For example, first circuit 430 can be part of return/ground path 322 of **FIG. 3****.** First circuit 430 can also provide power supply to, for example, driver circuits 306. Second circuit 440 (e.g., second circuits 440a, 440b, 440c, etc.) can extend from second die 414 to each of first dies 412a, 412b, and 412c. Second circuit 440 can provide electrical connections between second die 414 and each of first dies 412a, 412b, and 412c. The electrical connections can be used to, for example, transmit data and control signals from second die 414 to first dies 412a-412c, transmit other signals from I/O bumps 422 to first dies 412a-412c, etc.

Circuit board 404 can include traces and pads. Some of the pads of circuit board 404 can be electrically connected to I/O bumps 422 of IC chip 402, whereas some of the pads of circuit board 404 can be electrically connected to, for example, power system 310, or other components. Circuit board 404 can provide electrical connections between power system 310 and each of first die 412, second 414, and LED devices 410. For example, return/ground path 322 of **FIG. 3** can be implemented via first circuit 430 and I/O bumps 422, as well as circuit board 404, between an uLED 308 and power system 310.

In the example of **FIG. 4A****,** first die 412 and second die 414 are arranged along a lateral direction (e.g., along the X or Y axis) within IC chip 402. In some examples, as shown in **FIG. 4B**, first die 412 and second die 414 can form a stack along the vertical direction, to further reduce the form factors of integrated circuit chip 402 and display system 400. As shown in FIG. 4A, first circuit 430 can extend along the vertical direction from front side 406 of IC chip 402 towards back side 408 of IC chip 402 and across a thickness of first die 412 and second die 414. In addition, a set of I/O bumps can be sandwiched between first die 412 and second die 414 as part of second circuit 440.

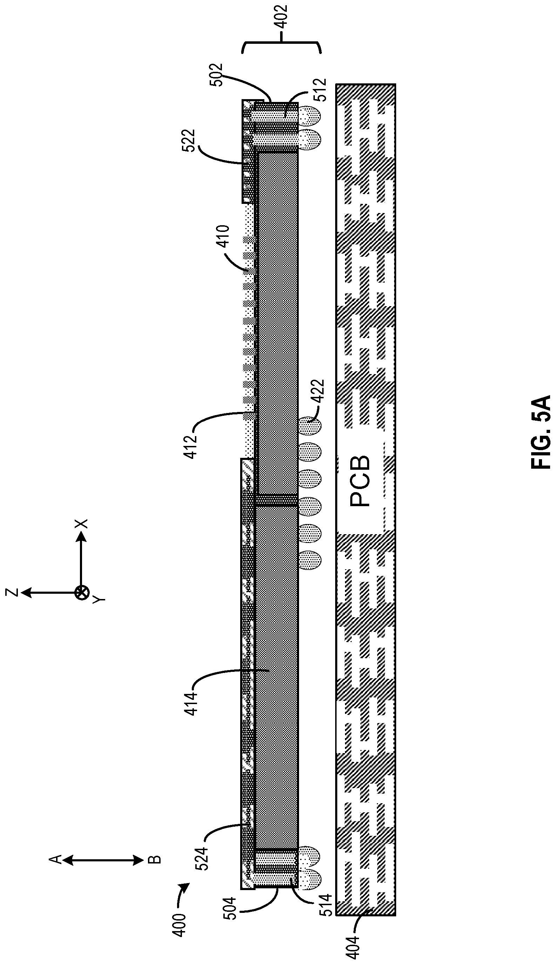

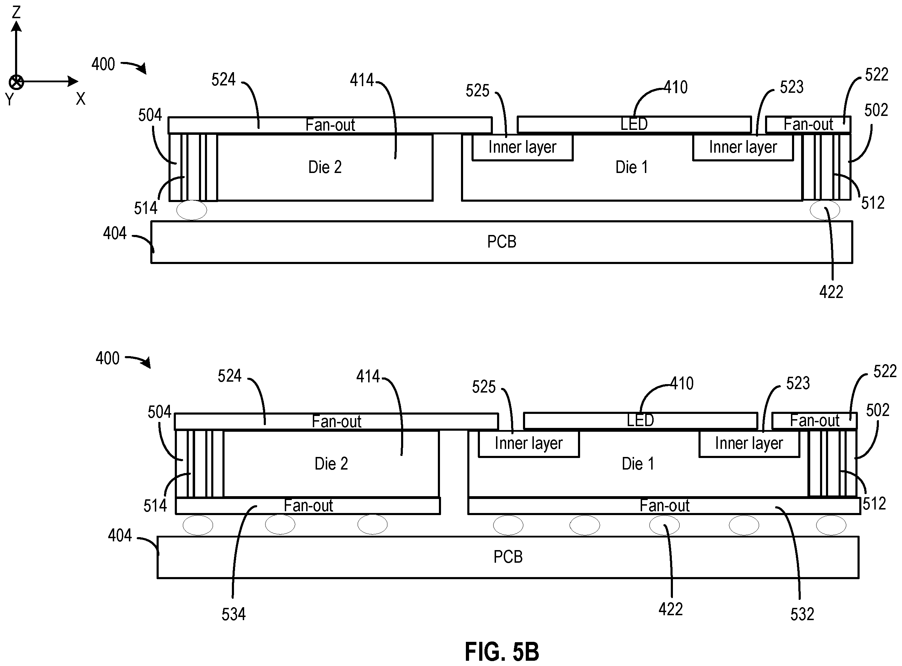

**FIG. 5A** and **FIG. 5B** illustrate examples of display system 400 of **FIG. 4A** in which first die 412 and second die 414 are arranged along a lateral direction. As shown in **FIG. 5A**, IC chip 402 can include a shoulder structure 502 abutting first die 412 along the lateral direction (e.g., parallel with X or Y-axis) and a shoulder structure 504 abutting second die 414. Each of shoulder structures 502 and 504 may include, respectively, electrical conduction paths 512 and 524 that extend across a thickness of first die 412 or second die 414. Fan-out circuit 522 can be configured as a redistribution layer (RDL), which comprises a metal layer to provide electrical connections. **FIG. 5B** illustrates that fan-out circuit 522 can be electrically connected to an inner layer circuit 523 of first die 412 via I/O pads (not shown in **FIG. 5B**). Fan-out circuit 522 also extends over shoulder structure 502 and can be electrically connected to one end of electrical conduction paths 512. The other end of electrical conduction paths 512 can be electrically connected to at least some of I/O bumps 422. In some examples, as shown in the top diagram of **FIG. 5B**, I/O bumps 422 can be placed on the back side of shoulder structure 502 (e.g., a side facing towards direction B) and directly connected to electrical conduction paths 512. In some examples, as shown in the bottom diagram of **FIG. 5B**, IC chip 402 may include a fan-out circuit 532 configured as a back side RDL that extends from shoulder structure 502 to a back side of first die 412 (e.g., a side facing towards direction B), and the I/O bumps 422 can be positioned on the back side RDL. Electrical conduction paths 512 can be connected to the I/O bumps 422 via the back side RDL. In both examples, fan-out circuits 522 and/or 532, together with electrical conduction paths 512, can be part of first circuit 430 of **FIG. 4A** to provide electrical connections between LED devices 410 and I/O bumps 422. The use of a back side RDL can increase the number of I/O bumps 422 available and can be driven by a routing density.

In addition, IC chip 402 also includes a fan-out circuit 524 that extends from shoulder structure 504 over second die 414 to first die 412. Fan-out circuit 524 can also be configured as an RDL. In **FIG. 5B**, fan-out circuit 524 can be electrically connected to an inner layer circuit of second die 414 and an inner layer circuit 525 of first die 412 via I/O pads (not shown in **FIG. 5B**). Fan-out circuit 524 also extends over shoulder structure 504 and can be electrically connected to one end of electrical conduction paths 514. The other end of electrical conduction paths 514 can be electrically connected to at least some of I/O bumps 422. In some examples, as shown in the top diagram of **FIG. 5B**, I/O bumps 422 can be placed on the back side of shoulder structure 504 (e.g., a side facing towards direction B) and directly connected to electrical conduction paths 514. In some examples, as shown in bottom diagram of **FIG. 5B**, the IC chip 402 may include another fan-out circuit configured as a back side RDL that extends from shoulder structure 504 to a back side of second die 414 (e.g., a side facing towards direction B), and the I/O bumps 424 can be positioned on the back side RDL. Electrical conduction paths 514 can be connected to the I/O bumps 422 via the back side RDL. In both examples, fan-out circuits 524 and/or 534 together with electrical paths 514 can be part of first circuit 430 of **FIG. 4A** to provide electrical connections between LED devices 410 and I/O bumps 422. In addition, fan-out circuit 524 and electrical paths 514 can also be part of second circuit 440 to provide electrical connections between second die 414 and first die 412 for, for example, transmission of power, control signals, data signals, etc.

Both shoulder structures 502 and 504 can be made of an epoxy molding compound (EMC). The shoulder structures can be fabricated when first die 412 and second die 414 are on a carrier substrate. For example, after first die 412 and second die 414 are transferred onto a carrier substrate, molds can be positioned adjacent to first die 412 and second die 414 on the carrier substrate, and the molds can be filled with EMC to form the shoulder structures. In certain embodiments, shoulder structure 502 and 504 may be parts of a uni-body packaging structure formed around first die 412 and second die 414. Moreover, electrical conduction paths 512 and 514 can be made of copper and can be fabricated by, for example, drilling through holes through shoulder structures 502 and 504 and depositing copper into the through holes.

Fan-out circuits 522 and 524 can be formed in a fan-out process after shoulder structures 502 and 504 are formed. Two types of fan-out processes can be used to form fan-out circuits 522 and 524. A first type of fan-out process can be a face-down process in which dies 412 and 414 are placed face down on a flat carrier to ensure co-planarity of the die surfaces. Shoulder structures 502 and 504 can also be formed on the flat surface and become co-planar with dies 412 and 414. The flat carrier is then removed (e.g., by etching away) to expose the die surfaces, and fan-out circuits 522 and 524 can then formed on the exposed surface. A second type of fan-out process can be a face-up process in which dies 412 and 414 are placed face up on the carrier. A grinding process can be applied on the die surfaces of dies 412 and 414 to ensure co-planarity. In some examples, process bumps can be formed on the die surfaces to accommodate the lack of co-planarity. After the grinding process, some remnant of the process bumps may remain and can be used as I/O pads between the dies and the fan-out circuits.

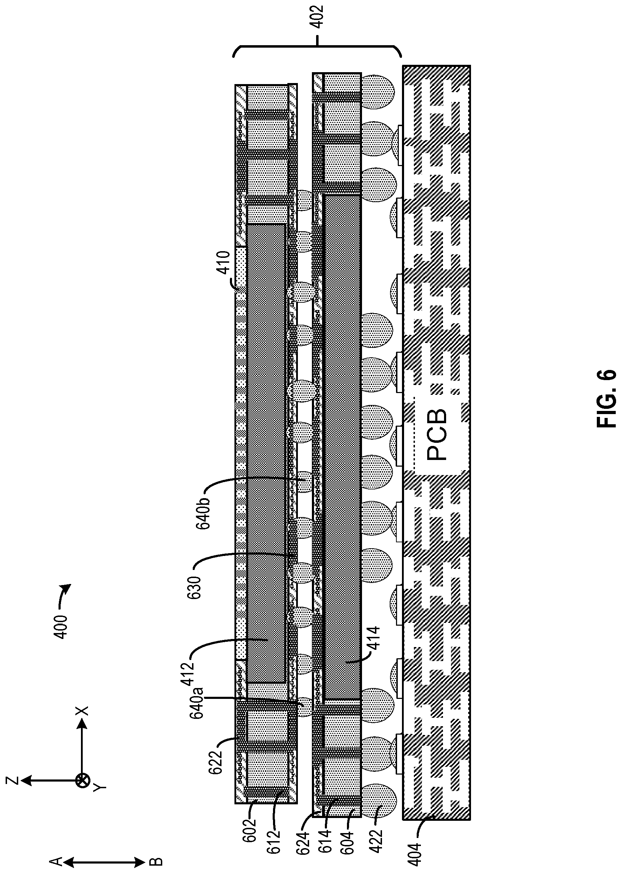

**FIG. 6** illustrates an example of display system 400 of **FIG. 4B** in which first die 412 and second die 414 are arranged in a stack along a vertical direction. As shown in **FIG. 6**, IC chip 402 includes a first shoulder structure 602 abutting first die 412 along the lateral direction and a second shoulder structure 604 abutting second die 414 along the lateral direction. First shoulder structure 602 includes first electrical conduction paths 612 that extend along the vertical direction and across a thickness of first die 412, whereas second shoulder structure 604 includes second electrical conduction paths 614 that extend along the vertical direction and across a thickness of second die 414. IC chip 402 further includes a first fan-out circuit 622 that extends from first shoulder structure 602 to first die 412 to provide electrical connections between LED devices 410 and first electrical conduction paths 612 (via an inner layer circuit of first die 412). IC chip 402 further includes a second fan-out circuit 624 that extends from second shoulder structure 604 to second die 414 to provide electrical connections between the second electrical conduction paths 614 and second die 414. Second electrical conduction paths 614 can be electrically connected to at least some of I/O bumps 422, whereas first electrical conduction paths 612 are electrically connected to second electrical conduction paths 614. Through first electrical conduction path 612 and second electrical conduction path 614, electrical connections can be provided between LED devices 410 and I/O bumps 422, and between first die 412 and second die 414. Both first fan-out circuit 622 and second fan-out circuit 624 are configured as an RDL layer, according to various embodiments of the disclosure.

There are various ways to electrically connect between first electrical conduction path 612 and second electrical conduction path 614. For example, I/O bumps 640 (e.g., I/O bump 640a) can be sandwiched between first shoulder structure 602 and second shoulder structure 604 (and between first electrical conduction path 612 and second electrical conduction path 614) to provide the electrical connections. As another example, as shown in **FIG. 6**, IC chip 402 may further include a back side fan-out circuit 630 formed on a backside of first die 412 (facing towards direction B). Back side fan-out circuit 630 can extend over to second shoulder structure 614 and is electrically connected to second electrical conduction paths 614. Back side fan-out circuit 630 forms opposite RDL layers with fan-out circuit 624 (on second die 414). I/O bumps 640 (e.g., I/O bump 640b) can be sandwiched between the opposite RDL layers to provide electrical connections between the opposite RDL layers and first electrical conduction path 612 and second electrical conduction path 614.

In addition, I/O bumps 422 can be distributed based on the examples of **FIG. 5B****.** For example, I/O bumps 422 can be placed only under second shoulder structure 604, or over another back side RDL layer under second die 414.

There are various advantages with the arrangements of **FIG. 6****.** For example, the stack structure can reduce the foot print of IC chip 402. Moreover, as the sizes of shoulder structures are flexible and can be expanded to accommodate more I/O bumps, the number of I/O bumps 640 (between the first die and the second die) and the number of I/O bumps 422 (between the second die and the circuit board) can be largely independent of the sizes of the first die and the second die, which adds flexibility to the fabrication and application of IC chip 402.

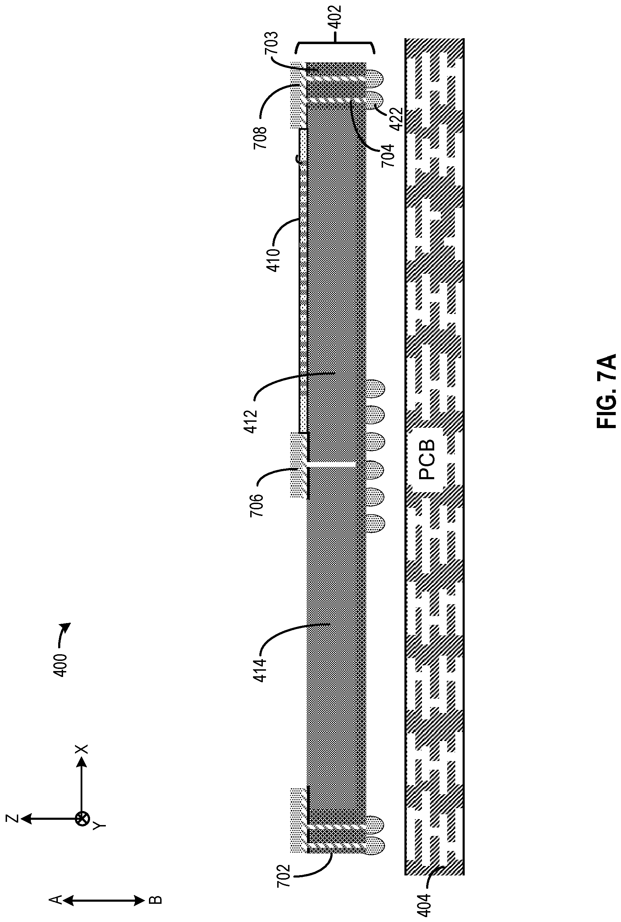

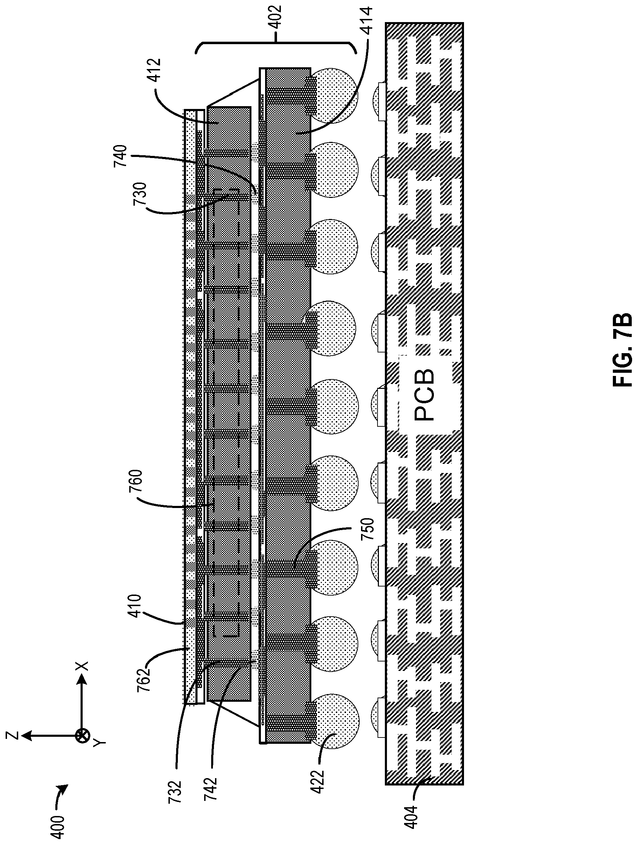

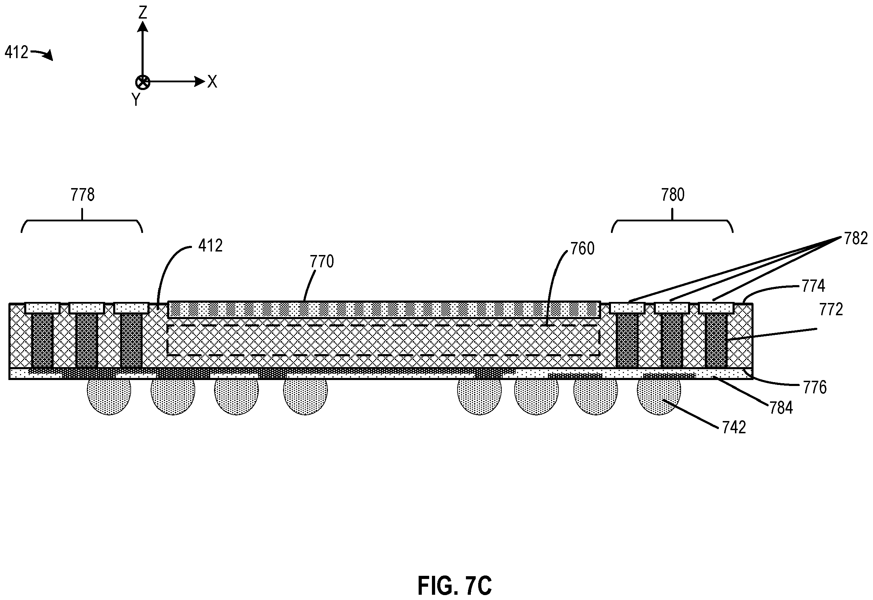

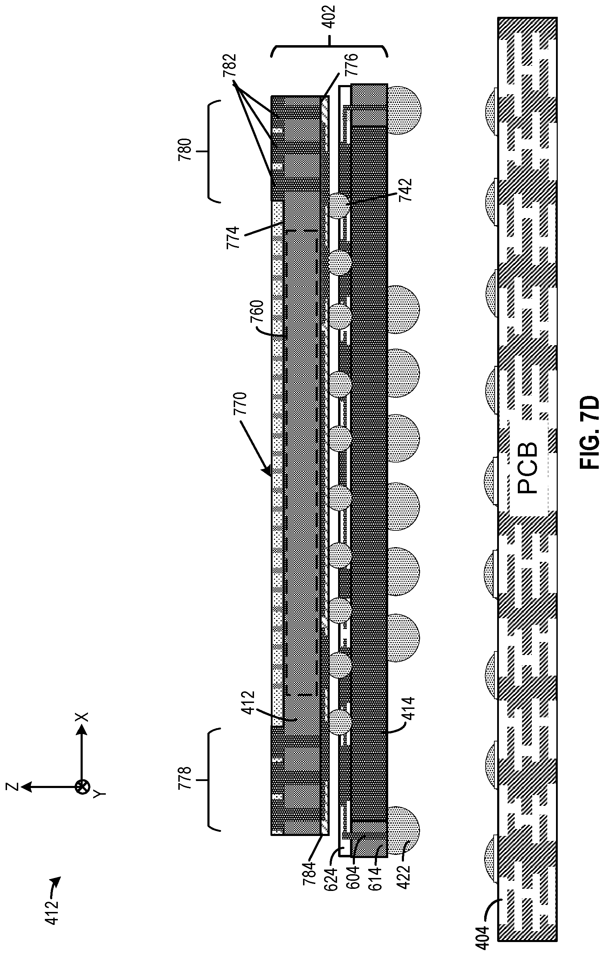

**FIG. 7A**, **FIG. 7B**, **FIG. 7C**, and **FIG. 7D** illustrate other example structures of IC chip 402. As shown in **FIG. 7A**, IC chip 402 can include a chip carrier 702 that holds first die 412 and second die 414, with the dies being arranged along a lateral direction (e.g., parallel with X/Y axes). Chip carrier 702 further includes shoulder structures 703 which can hold electrical conduction paths 704 that extend along a vertical direction (e.g., along the Z axis) and across a thickness of first die 412. IC chip 402 further includes bridge circuits 706 and 708. Bridge circuit 706 can provide electrical connections between first die 412 and second die 414. Bridge circuit 708 can provide electrical connections between first die 412 (and LED devices 410) and electrical conduction paths 704. Electrical conduction paths 704 are also electrically connected to I/O bumps 422. Bridge circuit 708 and electrical conduction paths 704 can provide electrical connections between LED devices 410 and I/O bumps 422.

**FIG. 7B** illustrates an example of IC chip 402 in which first die 412 and second die 414 form a stack. In **FIG. 7B**, each of first die 412 and second die 414 include through silicon vias (TSV) that extends vertically (along the Z axis) through the dies. Electrical connections between LED devices 410 and I/O bumps 422 can be provided by, for example, TSV 730 of first die 412, I/O bump 740, and TSV 750 of second die 414. The electrical connections can be used to provide, for example, power to driver circuits 306 and current return paths 322. Moreover, electrical connections between first die 412 and second die 414 can be provided TSV 732 of first die 412 and I/O bump 742. Fan-out circuits may be formed on the first die and the second die to provide electrical connections to bumps 740/742 and I/O bumps 422.

The arrangements in **FIG. 7B** can provide numerous advantages. First, the package size can be reduced, as the electrical paths between LED devices 410 and bumps 740/742 (e.g., return path 322, power line, etc., as represented by first circuit 430) are confined within first die 412. Therefore, no external structure is needed to be positioned lateral to first die 412 (along the X/Y axes), as shoulder structure 602 of **FIG. 6** and shoulder structure 703 of **FIG. 7A** to hold the electrical paths, which can reduce the footprint of IC chip 402. Moreover, some or all of the TSVs of first die 412 (e.g., TSV 730) can be formed in an active area 760 underneath a pixel area include LED devices 410. Active area 760 may include, e.g., driver circuits 306 and other semiconductor devices that control LED devices 410. Having the TSVs passing through active area 760 within first die 412 can further reduce the routing distances for the power and return paths implemented with the TSVs, which can improve the robustness of the power and ground system.

The arrangements in **FIG. 7B****,** however, can pose numerous challenges in a case where the TSVs are fabricated after the LED devices 410 are placed onto first die 412. Specifically, the TSVs can be formed by etching trenches vertically from front side 762 through first die 412, followed by filling the trenches with metal (or other conductive materials). But the etching can potentially damage LED devices 410, and special care may be needed to protect LED devices 410 from the etching action, such as creating keep-out zones in active area 760 in which the driver circuits and LED devices 410 are not to be placed, to provide more isolations between LED devices 410 and the TSVs. But such arrangements can add complexity to the processes of fabricating the TSVs, first die 412, as well as IC chip 402 as a whole. Typically the TSVs in **FIG. 7B** need to be fabricated as part of the fabrication process of first die 412, such that the placements of the active devices and the TSVs in first die 412 can satisfy the limitations imposed by the keep-out zones.

**FIG. 7C** illustrates another example of first die 412 which includes an alternative arrangements of TSVs and can be part of IC chip 402. As shown in **FIG. 7C**, first die 412 includes active area 760, and a pixel area 770 including LED devices 410 stacks on top of active area 760. First die 412 further includes TSV 772 which extend vertically (along the Z axis) through a thickness of first die 412 from a front side 774 (facing the positive Z direction) of first die 412 to a back side 776 (facing the negative Z direction) of first die 412. Unlike the TSVs of **FIG. 7B**, the TSVs in the example of **FIG. 7C** are formed in peripheral areas 778 and 780 of first die 412 that are outside of active region 760. First die 412 further includes bonding pads 782 formed on front side 774, and electrical bridge structures (not shown in **FIG. 7C**) can provide electrical connections between pixel area 770 and the TSVs via the bonding pads 782. Moreover, a metal layer 784 (e.g., a redistribution layer) can be formed on back side 776 of first die 412 to provide electrical connections from the TSVs to I/O bumps on the back side (e.g., I/O bump 742).

As in the arrangements of TSVs in **FIG. 7B**, the arrangements of TSVs in **FIG. 7C** allows the package size to be reduced by confining the electrical paths between LED devices 410 and bump 742 (e.g., return path 322, power line, etc., as represented by first circuit 430) within first die 412. However, as the TSVs are formed in a separate area from active area 760 and pixel area 770, the fabrication of the TSVs pose much lower risk to LED devices 410 in pixel area 770, especially in a case where in a case where the TSVs are fabricated after the LED devices 410 are placed onto first die 412. Compared with **FIG. 7B**, the fabrication of TSVs in **FIG. 7C** can be performed using less sophisticated processes. For example, as described above, the TSVs in **FIG. 7B** need to be fabricated as part of the fabrication process of first die 412, such that the placements of the active devices and the TSVs in first die 412 can satisfy the limitations imposed by the keep-out zones. But in the example of **FIG. 7C**, since the active devices and the TSVs are kept in different areas, there is no need to provide keep-out zones in active area 760, and the fabrication and placement of the active devices in active area 760 need not take into account the TSVs. Moreover, the fabrication of the TSVs can be performed outside the fabrication process of the devices within first die 412. Instead, the fabrication of the TSVs in **FIG. 7C** can be part of a post-processing in a packaging operation of forming IC chip 402. As a result, the arrangements of TSVs in **FIG. 7C** can reduce the complexity of fabrication of the TSVs, as well as the formation of IC chip 402 as a whole, while reducing the chip footprint and providing robust electrical connection between LED devices 410 on the front side and bumps on the back side of first die 412.

First die 412 formed using the TSV arrangements in **FIG. 7C** can be combined with second die 414 formed using various techniques in this disclosure to form IC chip 402. As an example, first die of FIG. 7C can be combined with second die 414 of **FIG. 7B** to form IC chip 402. As another example, as shown in **FIG. 7D**, first die 412 of **FIG. 7C** can be combined with second die 414 of **FIG. 6** to form IC chip 402. As described above, second die 414 in the example of **FIG. 6** includes second shoulder structure 604, which includes second electrical conduction paths 614 that extend along the vertical direction and across a thickness of second die 414. IC chip 402 further includes second fan-out circuit 624, which can be configured as an RDL layer and can extend from second shoulder structure 604 to second die 414 to provide electrical connections between the second electrical conduction paths 614 and second die 414. Advantages provided by the arrangements of **FIG. 7D** may include, for example, the die size of second die 414 being independent from the die size of first die 412, as second shoulder structure 606 can be made such that the overall footprint of second die 414 with second shoulder structure 606 matches the overall footprint of first die 414. Moreover, as explained above, the shoulder structures can be expanded to accommodate more I/O bumps, the number of I/O bumps 640 (between the first die and the second die) and the number of I/O bumps 422 (between the second die and the circuit board) can be largely independent of the sizes of the first die and the second die, which adds flexibility to the fabrication and application of IC chip 402.

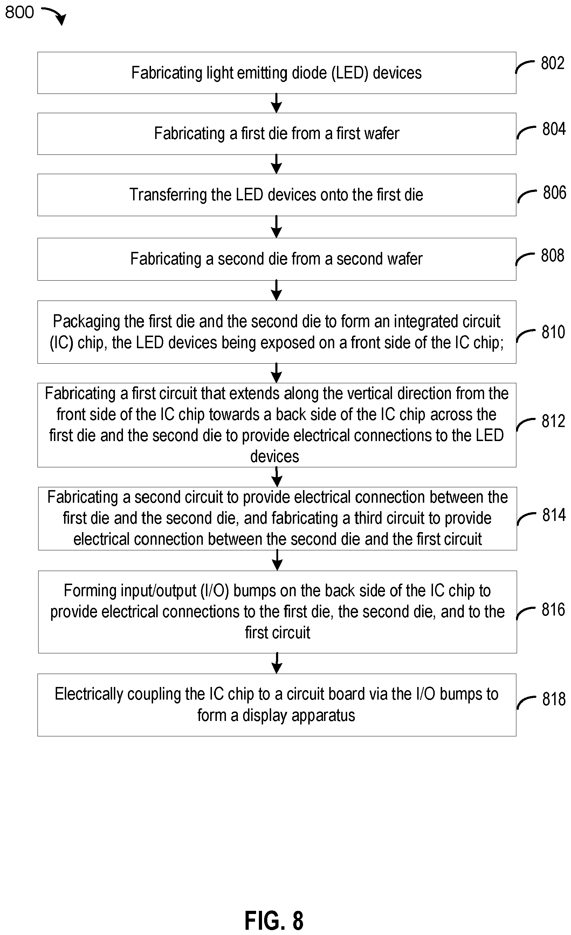

**FIG. 8** illustrates a method 800 of manufacturing a display system, such as display system 400. Method 800 starts with step 802, in which light emitting diode (LED) devices are fabricated. The LED devices can be fabricated from, for example, a crystal wafer (e.g., sapphire).

In step 804, a first die can be fabricated from a first wafer. The first die can include driver circuits for the LED devices.

In step 806, the LED devices can be transferred onto the first die by, for example, bonding the LED devices with the first die.

In step 808, a second die can be fabricated from a second wafer. The second die can include control circuits for the driver circuits. The second wafer can have different process nodes from the first wafer.

In step 810, the first die and the second die can be packaged to form an integrated circuit (IC) chip, the LED devices being exposed on a front side of the IC chip. The packaged IC chip can be according the examples of **FIG. 4A** to **FIG. 7B****.**

In step 812, a first circuit can be fabricated within the IC chip. The first circuit extends along the vertical direction from the front side of the IC chip towards a back side of the IC chip across the first die to provide electrical connections to the LED devices. In some examples, the first circuit can be part of a shoulder structure abutting the dies. In some examples, the first circuit can be TSVs formed across the thickness of the first die. In some examples, the TSVs can be formed within the active area of first die which contains driver circuits for the LED devices. In some examples, the TSVs can be formed in a peripheral area of the first die that is outside the active area as well as the pixel area that contains the LED devices. The TSVs can be formed by etching through a first surface of the first die after the LED devices are transferred on the first surface of the first die which includes the driver circuit in step 806.

In step 814, a second circuit can be fabricated within the IC chip. The second circuit can provide electrical connection between the first die and the second die and can include fan-out circuits. Further, a third circuit may be added in the vertical direction, such as the shoulder of the second die that forms a connection through vertical interconnects 604 and 612.

In step 816, input/output (I/O) bumps are formed on the back side of the IC chip to provide electrical connections to the first die, the second die, and to the first circuit.

In step 818, the IC chip is electrically coupled to a circuit board via the I/O bumps to form a display apparatus.

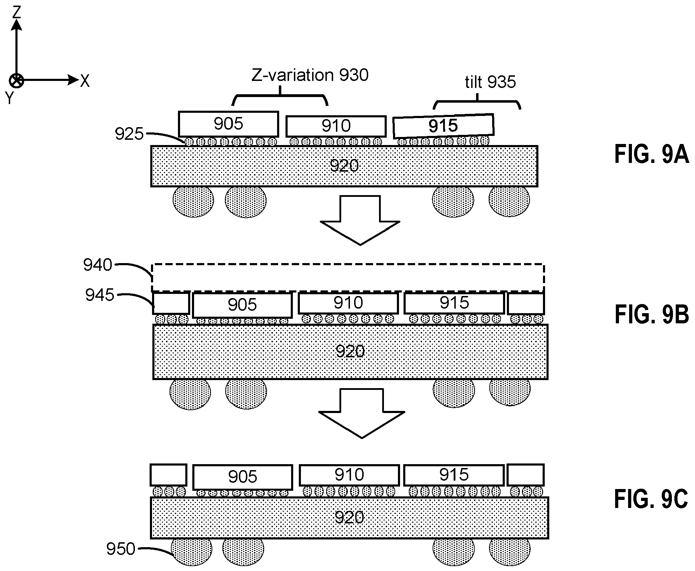

**FIG. 9A, FIG. 9B,** and **FIG. 9C** illustrate an example of a method for reducing the planarity variation in a display device according to the invention. As shown in **FIG. 9A**, a display device may include die 905, die 910, and die 915, each of which is mounted on a backplane 920 via I/O bumps 925. Die 905 may include an array of LEDs that are configured to emit red light, such as the first array 281 of LEDs shown in **FIG. 2E****.** Die 910 may include an array of LEDs that are configured to emit green light, such as the second array 282 of LEDs shown in **FIG. 2E****.** Die 915 may include an array of LEDs that are configured to emit blue light, such as the third array 283 of LEDs shown in **FIG. 2E****.** Each array of LEDs may be configured to face in an upward direction (i.e., away from the backplane 920). Each array of LEDs may be a one-dimensional array or a two-dimensional array. Although the dies 905, 910, and 915 are shown as being formed in a line along the x direction, they may be staggered along the x direction and/or the y direction. For example, the dies 905, 910, and 915 may be arbitrarily arranged with respect to each other along the x and y axes, as shown in **FIG. 2F****.** The backplane 920 may include a chip that drives the dies 905, 910, and 915. Additional I/O bumps 950 may be provided on the underside of the backplane 920 in order to provide a connection between the backplane 920 and a sensor aggregation chip.

Each die 905, 910, and 915 may be individually processed and mounted to the backplane 920. This may cause a variation 930 in the height of the dies 905, 910, and 915 along the z direction. For example, the top surface of die 905 may be higher (i.e., farther away from the backplane 920) than the top surface of die 910. This may be caused by differences in the thicknesses of dies 905 and 910, and/or a variation in the volume of the I/O bumps 925 between the dies 905 and 910 and the backplane 920. Alternatively or in addition, any of the dies 905, 910, or 915 may be tilted with respect to the backplane 920. For example, die 915 may be tilted such that its top surface makes an angle with respect to the backplane 920. This tilt 935 may be caused by a tilt in the top surface of die 915, a variation in the volume of the I/O bumps 925 between die 915 and the backplane 920, and/or a variation in the size of the bonding pads to which the die 915 is connected. Alternatively or in addition, the top surface of any of the dies 905, 910, or 915 may be warped, such that the top surface is not flat. In combination, these effects may result in a total planarity variation of the top surface of the display device (i.e., the surface defined by the top surfaces of the dies 905, 910, and 915) that is between 50 µm and 100 µm. More specifically, the total planarity variation may be defined as the difference between the highest point within the top surfaces of the dies 905, 910, and 915 and the lowest point within the top surfaces of the dies 905, 910, and 915 along the z direction. For example, the highest point may be the highest point of the top surface of die 905, and the lowest point may be the lowest point of the top surface of die 905 or 910.

As discussed above with respect to **FIG. 2E**, collimating lenses may be provided to collimate light from the LEDs. One collimating lens may be provided for each die 905, 910, and 915 . Further, a single waveguide may be provided to receive light from the collimating lenses and to direct light to the user's eye. In an ideal display device, the top surface of each die 905, 910, and 915 is planar, the top surface of each die 905, 910, and 915 lies in the x-y plane, the optical axis of each collimating lens is perpendicular to the top surface of the respective die 905, 910, or 915, and the propagation direction of the waveguide is perpendicular to the optical axis of each collimating lens. It may be possible to make small corrections for variations from the ideal display device. However, because there is limited space between the collimating lenses and the waveguide, these corrections are generally limited to compensating for variations of about 10 µm. For example, if die 915 is tilted, the collimating lens corresponding to die 915 may also be tilted at a similar angle. However, this may cause beam walk-off, in which light emitted from the collimating lens falls on the waveguide at a non-ideal location, which causes the brightness of the blue light to decrease. Also, there may be insufficient space between the collimating lens and the waveguide to fully compensate for the tilt. Further, if the height of die 905 is greater than the ideal height, the height of the collimating lens corresponding to die 905 may be increased by a similar amount. However, there may be insufficient space between the collimating lens and the waveguide to fully compensate for the difference in height.

**FIG. 9B** shows an example of a method for reducing this planarity variation. As shown in **FIG. 9B**, according to the invention a material 940 is placed on the top surface of the display device. For example, the material 940 may have a flat bottom surface and/or a flat top surface, and may be a glass slide, a metal plate, or another suitable material. The material 940 may be an inert material, such as quartz, which is stable over a wide range of temperatures. This may prevent the top surface of the display device from being damaged. In a first example, the material 940 may be placed on the top surface of the display device during reflow of the fusible material used to form the I/O bumps 925 between the dies 905, 910, and 915 and the backplane 920. For example, the fusible material may be solder or another metal, such as a Bi alloy. According to the invention, the only pressure applied to the top surface of the display device is the weight of the material 940. No additional pressure is applied.

During reflow, the display device may be passed through an oven having a temperature of up to approximately 250 °C, which causes the fusible interconnections between the dies 905, 910, and 915 and the backplane 920 to turn to liquid. The temperature of the oven may be set to the melting point of the fusible material used to form the I/O bumps 925 between the dies 905, 910, and 915 and the backplane 920, which may have a higher melting point than the fusible material used to form the I/O bumps 950 between the backplane 920 and the sensor aggregation chip. The weight of the material 940 may be chosen such that gravity and surface tension cause the material 940 to improve the co-planarity of the dies 905, 910, and 915 without over-collapsing the dies 905, 910, and 915 onto the backplane 920. Further, spacers 945 may be added adjacent to the dies 905, 910, and 915 to prevent over-collapse of the dies 905, 910, and 915. The bottom surface of the material 940 effectively becomes a reference plane, and variations in the planarity are absorbed by the fusible material. For example, any tilt in the dies 905, 910, and 915 may be reduced or eliminated, and bottom surface of the material 940 may be pressed against the top surfaces of the dies 905, 910, and 915, such that the top surface of each die 905, 910, and 915 is at approximately the same height in the z direction. Once the display device has been cooled to room temperature, the dies 905, 910, and 915 may be attached to the backplane 920 via the I/O bumps 925.

In some examples, a protective film may be applied to the top surface of the display device before the material 940 is placed on the top surface. The protective film may be made of Si or a polyamide. For example, the protective film may be an electronic grade Si film adhesive or a thermoplastic material that can be pressed into place. Particles from the fusible material may adhere to the protective film during processing, and these particles would be removed when the protective film is removed after processing. Therefore, the particles would not affect the top surface of the display device.

More generally, a variety of combinations of the pressure applied by the material 940 and any heat applied to the display device may be used to reduce the planarity variation. In the first example discussed above, a combination of a low pressure and a high temperature may be used. In the first example, the low pressure corresponds to the weight of the material 940 and the high temperature corresponds to the melting point of the fusible material between the dies 905, 910, and 915 and the backplane 920. In a second example, a combination of a high pressure and a low temperature may be used. In the second example, the high pressure corresponds to a yield strength of the fusible material between the dies 905, 910, and 915 and the backplane 920 at room temperature and the low temperature corresponds to the room temperature. The room temperature may have a value between 15 °C and 25 °C. The room temperature may be defined as the ambient temperature surrounding the display device, such that no additional heating or cooling is applied specifically to the display device while the pressure is applied. The display device may not be passed through the oven if the room temperature is used. The high pressure may be achieved by applying a downward force to the material 940. Any suitable combination of the pressure and the temperature may be used. In other examples, the pressure may be between the low pressure and the high pressure described above, and the temperature may be between the low temperature and the high temperature described above. In a third example, a downward force may be applied to the material 940 while the display device is heated to a temperature below the melting point of the fusible material between the dies 905, 910, and 915 and the backplane 920, which softens the fusible material but does not turn the fusible material to liquid. Again, the variations in the planarity are absorbed by the fusible material.

In the examples discussed above, a single combination of the pressure and the temperature may be used to reduce the planarity variation of the top surface of the display device. In other examples, multiple combinations of the pressure and the temperature may be used to reduce the planarity variation. In a fourth example, a two-step approach may be used in which a first combination is used during reflow to reduce a majority of the planarity variation, and a second combination is subsequently used to reduce and/or eliminate any remaining planarity variation that may be induced during or after additional processing such as underfilling. The first combination may use a low pressure and a high temperature, while the second combination may use a high pressure and a low temperature.

In some embodiments, the gap between the dies 905, 910, and 915 and the backplane 920 may be underfilled with a polymer material after reflow of the fusible material. The polymer material may be disposed on a lateral side of the display device, and may flow by capillary action into the gap. Alternatively, the polymer material may be applied before reflow of the fusible material. In this example, the polymer material is applied in a liquid state and dispensed at positions on the backplane 920 where the dies 905, 910, and 915 will be landing. The polymer material then solidifies during the reflow of the fusible material. The cooling of the fusible material may be designed such that cross-linking of the polymer with the fusible material is 50% complete.

Further, in some embodiments, at least one spacer 945 may be used to provide a reference plane for the collimating lenses. The at least one spacer 945 may be a structure having a similar thickness to the dies 905, 910, and 915, but the at least one spacer 945 may not emit light. In the example shown in **FIG. 9B**, a spacer 945 may be positioned to the left of die 905 or to the right of die 915. In other examples, a spacer may be provided for each of the dies 905, 910, and 915. The at least one spacer 945 indicates where the collimating lenses should land during placement. The at least one spacer 945 may be made of silicon or another suitable material.

Additionally, in some embodiments, the bottom surface of the material 940 may have a shape that complements and offsets an anticipated incremental planarity variation that is caused by downstream processing. The downstream processing may include any processing that occurs after the melting of the fusible material during reflow, such as the cool down from the reflow temperature to room temperature, underfilling, and mounting of the display device to a PC board. The planarity variation induced by the downstream processing may be manifested as a uniform warpage or curvature, and therefore may be systematic and repeatable. For example, the warpage or curvature induced during the cool down from the reflow temperature is caused by the mismatch in the coefficient of thermal expansion (CTE) between the materials in the display package, and it is the same for a given package structure and dimensions. Similarly, the warpage or curvature induced by underfilling is caused by the shrinkage of the underfill material, is concave, and is the same for a given package structure and dimensions.

One way to address the warpage or curvature induced by the downstream processing is to create an intentional opposite curvature during the reflow step with a material 940 that is intentionally shaped and is not flat. For example, if it is known that the downstream processing will induce a net concave warpage/curvature of "x", the bottom surface of the material 940 may be designed to impart a slightly convex shape (instead of a flat shape) with a curvature of magnitude "x" during reflow, so that after downstream processing the superposition of a positive "x" curvature and a negative "x" curvature cancels out, leaving a flat top surface of the display device at the end of processing. For example, the bottom surface of the material 940 may have a concave shape or a convex shape with a predetermined radius of curvature. Alternatively or in addition, the bottom surface of the material 940 may have any shape that offsets the planarity variation that is anticipated to be caused by the downstream processing.

**FIG. 9C** shows an example of a display device having a reduced planarity variation. As shown in **FIG. 9C**, the top surfaces of the dies 905, 910, and 915 are approximately coplanar. Further, the top surfaces of the dies 905, 910, and 915 are approximately parallel to the top surface of the backplane 920. For example, the total planarity variation of the top surface of the display device, as defined by the top surfaces of the dies 905, 910, and 915, may be reduced to a value between 0.1 µm and 10 µm. As discussed above, the total planarity variation may be defined as the difference between the highest point within the top surfaces of the dies 905, 910, and 915 and the lowest point within the top surfaces of the dies 905, 910, and 915 along the z direction.

The methods of reducing the planarity variation may be applied to display devices that are interconnected by various methods. For example, the methods for reducing the planarity variation may be applied to bonding processes in which the dies 905, 910, and 915 are bonded to the backplane 920 and then the individual LEDs are bonded to the dies 905, 910, and 915. Alternatively, the methods for reducing the planarity variation may be applied bonding processes in which the individual LEDs are bonded to the dies 905, 910, and 915 and then the dies 905, 910, and 915 are mounted on the backplane 920. In some embodiments, the planarization of the dies 905, 910, and 915 may be performed before the backplane 920 is interconnected to the sensor aggregation chip. In other embodiments, the backplane 920 may be interconnected to the sensor aggregation chip, then the dies 905, 910, and 915 may be bonded to the backplane 920, after which planarization of the dies 905, 910, and 915 may be performed. More generally, the steps of planarizing the dies 905, 910, and 915, bonding the dies 905, 910, and 915 to the backplane 920, bonding the individual LEDs to the dies 905, 910, and 915, and interconnecting the backplane 920 to the sensor aggregation chip may be performed in various sequences.

The foregoing description of the embodiments of the disclosure has been presented for the purpose of illustration; it is not intended to be exhaustive or to limit the disclosure to the precise forms disclosed. Persons skilled in the relevant art can appreciate that many modifications and variations are possible in light of the above disclosure.

Some portions of this description describe the embodiments of the disclosure in terms of algorithms and symbolic representations of operations on information. These algorithmic descriptions and representations are commonly used by those skilled in the data processing arts to convey the substance of their work effectively to others skilled in the art. These operations, while described functionally, computationally, or logically, are understood to be implemented by computer programs or equivalent electrical circuits, microcode, or the like. Furthermore, it has also proven convenient at times, to refer to these arrangements of operations as modules, without loss of generality. The described operations and their associated modules may be embodied in software, firmware, and/or hardware.

Steps, operations, or processes described may be performed or implemented with one or more hardware or software modules, alone or in combination with other devices. In some embodiments, a software module is implemented with a computer program product comprising a computer-readable medium containing computer program code, which can be executed by a computer processor for performing any or all of the steps, operations, or processes described.

Embodiments of the disclosure may also relate to an apparatus for performing the operations described. The apparatus may be specially constructed for the required purposes, and/or it may comprise a general-purpose computing device selectively activated or reconfigured by a computer program stored in the computer. Such a computer program may be stored in a non-transitory, tangible computer readable storage medium, or any type of media suitable for storing electronic instructions, which may be coupled to a computer system bus. Furthermore, any computing systems referred to in the specification may include a single processor or may be architectures employing multiple processor designs for increased computing capability.

Embodiments of the disclosure may also relate to a product that is produced by a computing process described herein. Such a product may comprise information resulting from a computing process, where the information is stored on a non-transitory, tangible computer readable storage medium and may include any embodiment of a computer program product or other data combination described herein.

The language used in the specification has been principally selected for readability and instructional purposes, and it may not have been selected to delineate or circumscribe the inventive subject matter. It is therefore intended that the scope of the disclosure be limited not by this detailed description, but rather by any claims that issue on an application based hereon. Accordingly, the disclosure of the embodiments is intended to be illustrative, but not limiting, of the scope of the disclosure, which is defined by the following claims.

## Claims

1. A method comprising:
applying a first pressure to a top surface of a display device at a first temperature, wherein:
the display device includes a backplane (920), a plurality of dies (905, 910, 920), and a plurality of fusible interconnections (950) between the backplane and the plurality of dies,
the first pressure is applied in a direction that is perpendicular to a plane of the backplane on which the plurality of dies are arranged, and
the first pressure and the first temperature are selected to cause the plurality of fusible interconnections to absorb variations in a planarity of the top surface of the display device;
and **characterized in that**,
the first pressure is provided solely by a weight of a material (940) that is placed on the top surface of the display device.

2. The method of claim 1, wherein the first temperature corresponds to a melting point of the plurality of fusible interconnections.

3. The method of claim 1 or claim 2, wherein a bottom surface of the material that contacts the top surface of the display device is flat.

4. The method of claim 1 or claim 2, wherein a bottom surface of the material that contacts the top surface of the display device is curved; and preferably wherein a curvature of the bottom surface of the material is determined based on a warpage of the top surface of the display device that is predicted to occur after a reflow of a fusible material that forms the plurality of fusible interconnections.

5. The method of any one of claims 1 to 4, wherein:
the first pressure corresponds to a yield strength of a fusible material of the plurality of fusible interconnections at room temperature, and
the first pressure is provided by a weight of a material that is placed on the top surface of the display device and an external force that is applied to the material.

6. The method of claim 5, wherein the first temperature corresponds to the room temperature.

7. The method of claim 5 or claim 6, wherein a bottom surface of the material that contacts the top surface of the display device is flat; or preferably wherein a bottom surface of the material that contacts the top surface of the display device is curved.

8. The method of claim 5, claim 6 or claim 7, wherein the fusible material comprises solder.

9. The method of any one of claims 1 to 8, further comprising:
applying a second pressure to the top surface of the display device at a second temperature, wherein:
the second pressure is applied after the first pressure is applied,
the second pressure is applied in the direction that is perpendicular to the plane of the backplane on which the plurality of dies are arranged, and
the second pressure and the second temperature are selected to cause the plurality of fusible interconnections to absorb further variations in the planarity of the top surface of the display device; and preferably wherein:
the second pressure is provided by the weight of the material that is placed on the top surface of the display device and an external force that is applied to the material.

10. The method of any one of claims 1 to 9, further comprising applying a protective film to the top surface of the display device before applying the first pressure to the top surface of the display device; and preferably wherein the protective film comprises an electronic grade Si film adhesive or a thermoplastic material.

11. The method of any one of claims 1 to 10, wherein the display device further includes at least one spacer that is arranged adjacent to the plurality of dies.

12. The method of any one of claims 1 to 11, wherein a fusible material of the plurality of the fusible interconnections comprises solder.

## Patentansprüche

1. Ein Verfahren, das Folgendes beinhaltet:
Aufbringen eines ersten Drucks auf eine obere Oberfläche einer Anzeigevorrichtung bei einer ersten Temperatur, wobei:
die Anzeigevorrichtung eine Rückwand (920), eine Vielzahl von Dies (905, 910, 920) und eine Vielzahl von schmelzbaren Zwischenverbindungen (950) zwischen der Rückwand und der Vielzahl von Dies umfasst,
der erste Druck in einer Richtung aufgebracht wird, die zu einer Ebene der Rückwand, auf der die Vielzahl von Dies angeordnet sind, senkrecht ist, und
der erste Druck und die erste Temperatur so ausgewählt werden, dass die Vielzahl von schmelzbaren Zwischenverbindungen veranlasst werden, Variationen einer Planarität der oberen Oberfläche der Anzeigevorrichtung zu absorbieren;
und **dadurch gekennzeichnet, dass**
der erste Druck allein durch ein Gewicht eines Materials (940), das auf die obere Oberfläche der Anzeigevorrichtung platziert wird, bereitgestellt wird.

2. Verfahren gemäß Anspruch 1, wobei die erste Temperatur einem Schmelzpunkt der Vielzahl von schmelzbaren Zwischenverbindungen entspricht.

3. Verfahren gemäß Anspruch 1 oder Anspruch 2, wobei eine untere Oberfläche des Materials, die die obere Oberfläche der Anzeigevorrichtung berührt, flach ist.

4. Verfahren gemäß Anspruch 1 oder Anspruch 2, wobei eine untere Oberfläche des Materials, die die obere Oberfläche der Anzeigevorrichtung berührt, gekrümmt ist; und bevorzugt wobei eine Krümmung der unteren Oberfläche des Materials basierend auf einer Wölbung der oberen Oberfläche der Anzeigevorrichtung bestimmt wird, von der vorhergesagt wird, dass sie nach einem Aufschmelzen eines schmelzbaren Materials, das die Vielzahl von schmelzbaren Zwischenverbindungen bildet, auftritt.

5. Verfahren gemäß einem der Ansprüche 1 bis 4, wobei:
der erste Druck einer Streckgrenze eines schmelzbaren Materials der Vielzahl von schmelzbaren Zwischenverbindungen bei Raumtemperatur entspricht und
der erste Druck durch ein Gewicht eines Materials, das auf die obere Oberfläche der Anzeigevorrichtung platziert wird, und eine externe Kraft, die auf das Material aufgebracht wird, bereitgestellt wird.

6. Verfahren gemäß Anspruch 5, wobei die erste Temperatur der Raumtemperatur entspricht.

7. Verfahren gemäß Anspruch 5 oder Anspruch 6, wobei eine untere Oberfläche des Materials, die die obere Oberfläche der Anzeigevorrichtung berührt, flach ist; oder bevorzugt wobei eine untere Oberfläche des Materials, die die obere Oberfläche der Anzeigevorrichtung berührt, gekrümmt ist.

8. Verfahren gemäß Anspruch 5, Anspruch 6 oder Anspruch 7, wobei das schmelzbare Material Lötmittel beinhaltet.

9. Verfahren gemäß einem der Ansprüche 1 bis 8, das ferner Folgendes beinhaltet:
Aufbringen eines zweiten Drucks auf die obere Oberfläche der Anzeigevorrichtung bei einer zweiten Temperatur, wobei:
der zweite Druck aufgebracht wird, nachdem der erste Druck aufgebracht wurde,
der zweite Druck in der Richtung aufgebracht wird, die zu der Ebene der Rückwand, auf der die Vielzahl von Dies angeordnet sind, senkrecht ist, und
der zweite Druck und die zweite Temperatur so ausgewählt werden, dass die Vielzahl von schmelzbaren Zwischenverbindungen veranlasst werden, weitere Variationen der Planarität der oberen Oberfläche der Anzeigevorrichtung zu absorbieren; und bevorzugt wobei:
der zweite Druck durch das Gewicht des Materials, das auf die obere Oberfläche der Anzeigevorrichtung platziert wird, und eine externe Kraft, die auf das Material aufgebracht wird, bereitgestellt wird.

10. Verfahren gemäß einem der Ansprüche 1 bis 9, das ferner das Aufbringen eines schützenden Films auf die obere Oberfläche der Anzeigevorrichtung vor dem Aufbringen des ersten Drucks auf die obere Oberfläche der Anzeigevorrichtung umfasst; und bevorzugt wobei der schützende Film einen für Elektronik geeigneten Si-Filmklebstoff oder ein thermoplastisches Material beinhaltet.

11. Verfahren gemäß einem der Ansprüche 1 bis 10, wobei die Anzeigevorrichtung ferner mindestens einen Abstandshalter, der neben der Vielzahl von Dies angeordnet ist, umfasst.

12. Verfahren gemäß einem der Ansprüche 1 bis 11, wobei ein schmelzbares Material der Vielzahl der schmelzbaren Zwischenverbindungen Lötmittel beinhaltet.

## Revendications

1. Un procédé comprenant :
l'application d'une première pression à une surface supérieure d'un dispositif d'affichage à une première température,
dans lequel :
le dispositif d'affichage inclut un fond de panier (920), une pluralité de puces (905, 910, 920), et une pluralité d'interconnexions fusibles (950) entre le fond de panier et la pluralité de puces,
la première pression est appliquée dans une direction qui est perpendiculaire à un plan du fond de panier sur lequel la pluralité de puces sont agencées, et
la première pression et la première température sont sélectionnées pour amener la pluralité d'interconnexions fusibles à absorber des variations d'une planéité de la surface supérieure du dispositif d'affichage ;
et **caractérisé en ce que**,
la première pression est fournie uniquement par un poids d'un matériau (940) qui est placé sur la surface supérieure du dispositif d'affichage.

2. Le procédé de la revendication 1, dans lequel la première température correspond à un point de fusion de la pluralité d'interconnexions fusibles.

3. Le procédé de la revendication 1 ou de la revendication 2, dans lequel une surface inférieure du matériau qui entre en contact avec la surface supérieure du dispositif d'affichage est plate.

4. Le procédé de la revendication 1 ou de la revendication 2, dans lequel une surface inférieure du matériau qui entre en contact avec la surface supérieure du dispositif d'affichage est incurvée ; et préférablement dans lequel une courbure de la surface inférieure du matériau est déterminée sur la base d'un gauchissement de la surface supérieure du dispositif d'affichage dont il est prédit qu'il se produise après une refusion d'un matériau fusible qui forme la pluralité d'interconnexions fusibles.

5. Le procédé de l'une quelconque des revendications 1 à 4, dans lequel :
la première pression correspond à une limite d'élasticité d'un matériau fusible de la pluralité d'interconnexions fusibles à température ambiante, et
la première pression est fournie par un poids d'un matériau qui est placé sur la surface supérieure du dispositif d'affichage et une force externe qui est appliquée au matériau.

6. Le procédé de la revendication 5, dans lequel la première température correspond à la température ambiante.

7. Le procédé de la revendication 5 ou de la revendication 6, dans lequel une surface inférieure du matériau qui entre en contact avec la surface supérieure du dispositif d'affichage est plate ; ou préférablement dans lequel une surface inférieure du matériau qui entre en contact avec la surface supérieure du dispositif d'affichage est incurvée.

8. Le procédé de la revendication 5, de la revendication 6 ou de la revendication 7, dans lequel le matériau fusible comprend une soudure.

9. Le procédé de l'une quelconque des revendications 1 à 8, comprenant en outre :
l'application d'une deuxième pression à la surface supérieure du dispositif d'affichage à une deuxième température, dans lequel :
la deuxième pression est appliquée après application de la première pression,
la deuxième pression est appliquée dans la direction qui est perpendiculaire au plan du fond de panier sur lequel la pluralité de puces sont agencées, et
la deuxième pression et la deuxième température sont sélectionnées pour amener la pluralité d'interconnexions fusibles à absorber d'autres variations de la planéité de la surface supérieure du dispositif d'affichage ; et préférablement dans lequel :
la deuxième pression est fournie par le poids du matériau qui est placé sur la surface supérieure du dispositif d'affichage et une force externe qui est appliquée au matériau.

10. Le procédé de l'une quelconque des revendications 1 à 9, comprenant en outre l'application d'un film protecteur à la surface supérieure du dispositif d'affichage avant l'application de la première pression à la surface supérieure du dispositif d'affichage ; et préférablement dans lequel le film protecteur comprend un adhésif de film Si de qualité électronique ou un matériau thermoplastique.

11. Le procédé de l'une quelconque des revendications 1 à 10, dans lequel le dispositif d'affichage inclut en outre au moins un espaceur qui est agencé de façon adjacente à la pluralité de puces.

12. Le procédé de l'une quelconque des revendications 1 à 11, dans lequel un matériau fusible de la pluralité des interconnexions fusibles comprend une soudure.
